Europäisches Patentamt

European Patent Office

Office européen des brevets

(11) Veröffentlichungsnummer: **0 236 936**
**A2**

# (12) EUROPÄISCHE PATENTANMELDUNG

(21) Anmeldenummer: 87103091.2

(22) Anmeldetag: 04.03.87

(51) Int. Cl.⁴: **H01L 31/18 , H01L 31/02**

(30) Priorität: 11.03.86 DE 3608074

(43) Veröffentlichungstag der Anmeldung:
16.09.87 Patentblatt 87/38

(84) Benannte Vertragsstaaten:
**DE FR GB**

(71) Anmelder: **Siemens Aktiengesellschaft Berlin und München**
**Wittelsbacherplatz 2**
**D-8000 München 2(DE)**

(72) Erfinder: **Juergens, Wilfried, Dipl.Phys.**
**Kastellburgstrasse 27**
**D-8000 München 60(DE)**

(54) Verfahren zur Vermeidung von Kurzschlüssen bei der Herstellung von elektrischen Bauelementen, vorzugsweise von aus amorphen Siliziumschichten bestehenden Solarzellen.

(57) Bei der Herstellung von elektrischen Bauelemenöten mit zwei übereinanderliegenden, durch eine isolierende oder halbleitende Schicht (3) getrennten Kontaktelektroden (2, 6), insbesondere bei der Herstellung von Dünnschichtsolarzellen aus amorphem Silizium (3) werden die durch Fehlstellen (4) im amorphen Silizium (3) verursachten Kurzschlüsse zwischen Grund-und Deckelektroden (2, 6) dadurch vermieden, daß ein lichtempfindlicher Lack (5) auf die, die Kurzschlüsse verursachende amorphe Siliziumschicht (3) aufgebracht wird, der so beschaffen ist, daß nach seiner Belichtung (7) durch in der darunterliegenden Schicht (3) vorhandene Fehlstellen (4) eine andere Lacklöslichkeit auftritt als in den übrigen Bereichen. Diese unterschiedliche Lacklöslichkeit (5, 5a) wird zur Erzeugung einer die Kurzschlüsse unterbindenden Isolationszone (5a) ausgenutzt. Das Verfahren wird verwendet vorzugsweise bei der Herstellung von großflächigen Solarzellen aus amorphem Silizium.

FIG 4

EP 0 236 936 A2

# Verfahren zur Vermeidung von Kurzschlüssen bei der Herstellung von elektrischen Bauelementen, vorzugsweise von aus amorphem Siliziumschichten bestehenden Solarzellen.

Die Erfindung betrifft ein Verfahren zur Vermeidung von Kurzschlüssen bei der Herstellung von elektrischen Bauelemeten mit zwei übereinanderliegenden, durch eine isolierende oder halbleitende Schicht getrennten Elektroden, insbesondere bei der Herstellung von aus amorphen Siliziumschichten bestehenden Dünnschichtsolarzellen, die durch Abscheiden der Schichtenfolge: transparente Grundelektrode -aktive amorphe Siliziumschicht -Deckelektrode auf großflächigen Substraten erzeugt werden.

Dünnschichtsolarzellen aus amorphem Silizium und ihre Wirkungsweise sind beispielsweise aus dem Buch "Amorphe und polykristalline Halbleiter" von W. Heywang, aus der Serie "Halbleiter-Elektronik", Band 18, Springer Verlag (1984) auf den Seiten 58 bis 64, zu entnehmen.

Bei großflächigen Solarzellen können erhebliche Ströme entstehen -so zum Beispiel bei einem Wirkungsgrad $\eta$ von 10 Prozent, einer Standardbelichtung von AM1 (= 100 mW/cm²) und 10 × 10 cm² Fläche größer als 1,5 Ampere -, so daß bei Serien-oder Übergangswiderständen nicht mehr vernachläßigbare Verluste auftreten. Bei Dünnschichtsolarzellen können, wenn die aktive Halbleiterschicht die Grundelektrode nicht dicht abdeckt (Fehlstellen im amorphen Silizium), zwischen den Elektroden Kurzschlüsse auftreten, die den Wirkungsgrad der Zellen erheblich beeinflussen.

Um den Serienwiderstand von Solarzellen zu verringern, werden sogenannte Fingerelektrodenstrukturen (grids) auf den Zellen aufgebracht; eine solche Solarzellenstruktur mit der Schichtenfolge: Substrat -Grundelektrode aus Molybdän -amorphes Silizium (nip) -semitransparente Deckelektrode aus mit Indium dotiertem Zinnoxid -Gridelektrode ist beispielsweise aus der europäischen Patentanmeldung 0 060 363 A1 bekannt. Kurzschlüsse zwischen Grundelektrode und der gut leitenden Deckelektrode im Bereich der Fingerelektrodestruktur sind besonders kritisch und können die Zellen unbrauchbar machen.

Um diese Schwierigkeiten zu umgehen, hat man bislang versucht, entweder durch Anlegen einer Spannung an die Deck-und Grundelektrode die Kurzschlüsse wegzubrennen, oder nach Feststellen der Fehlstelle im Silizium mit einem Sensor die Deck-und/oder Grundelektrode mit einem Laser zu entfernen (Wegbrennen). Die erstgenannte Methode hat den Nachteil, daß die Fehlstelle nicht zu hochohmig sein darf, damit ein genügend hoher Strom fließen kann und die Deckelektrode nicht zu dick sein darf. Die zweite Methode ist aufwendig und sehr teuer.

Aufgabe der Erfindung ist es, die durch Fehlstellen bedingten Kurzschlüsse sicher zu unterbinden, wobei insbesondere die bei der Abscheidung in der aus amorphen Silizium bestehenden halbleitenden Schicht der Solarzelle auftretenden Fehlstellen in wenig aufwendiger Weise beseitigt werden sollen.

Diese Aufgabe wird erfindungsgemäß dadurch gelöst, daß

a) ein lichtempfindlicher Lack ganzflächig auf die, die Kurzschlüsse verursachende isolierende oder halbleitende Schicht, die sich auf der ersten Elektrodenschicht befindet, aufgebracht wird, wobei der Lack so beschaffen ist, daß bei seiner Belichtung durch in der darunterliegenden isolierenden ober halbleitenden Schicht befindliche Fehlstellen oder Löcher in der darüberliegenden Lackschicht eine andere Lacklöslichkeit auftritt als in den übrigen Bereichen,

b) unter Ausnutzung der unterschiedlichen Lacklöslichkeiten der Lack auf der isolierenden oder halbleitenden Schicht selektiv entfernt wird,

c) die zweite Elektrodenschicht ganzflächig aufgebracht wird, und

d) wenn die belichteten Bereiche leichter löslich sind als die unbelichteten Bereiche vorher eine zusätzliche Isolationsschicht unter Verwendung der stehengebliebenen Lackstrukturen als Maske abgeschieden wird.

Dabei liegt es im Rahmen der Erfindung, daß bei der Herstellung von aus amorphen Siliziumschichten bestehenden Dünnschichtsolarzellen, die durch Abscheiden der speziellen Schichtenfolge: transparente Grundelektrode -aktive amorphe Siliziumschicht -Deckelektrode -auf großflächigen, transparenten Substraten erzeugt werden,

a) ein lichtempfindlicher und elektrisch isolierender, durch Belichtung vernetzender Lack auf die, die Kurzschlüsse verursachende aktive, amorphe Siliziumschicht, die sich auf der, auf dem transparenten Substrat angeordneten, transparenten Grundelektrodenschicht befindet, aufgebracht wird,

b) die Anordnung von der Substratseite her belichtet wird,

c) die durch Belichtung nicht vernetzten Teile der Lackschicht mit einem das amorphe Silizium nicht angreifenden Lösungsmittel entfernt werden und

d) die Deckelektrodenschicht ganzflächig auf die mit den vernetzten Lackstrukturen versehene Anordnung aufgebracht wird.

Weitere Ausgestaltungen der Erfindung ergeben sich aus den Unteransprüchen.

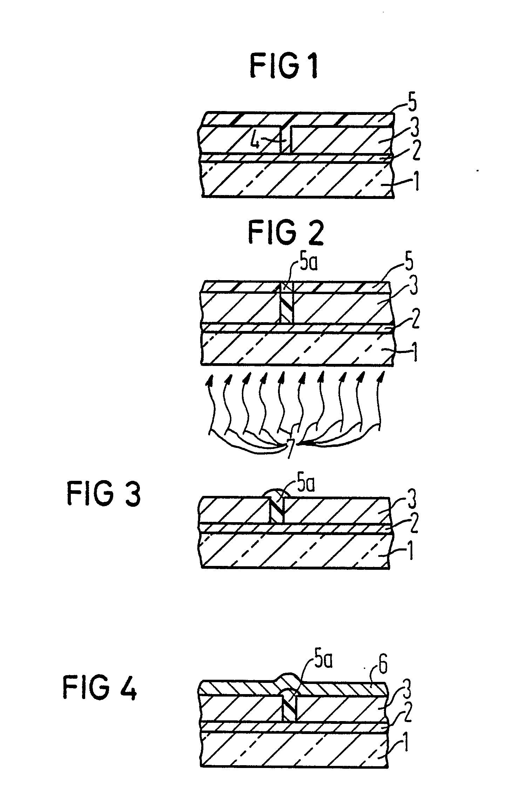

Im folgenden wird anhand der Figuren 1 bis 3 die Erfindung noch näher erläutert. Dabei zeigen

die Figuren im Schnittbild die erfindungswesentlichen Verfahrensschritte am Beispiel einer auf ein Glassubstrat aufgebrachten Solarzelle der Schichtstruktur: transparente, leitende Grundelektrode - (TCO = transparent conducting oxid) -aktive amorphe Siliziumschicht -Deckelektrode aus Silber.

Gleiche Teile sind in allen Figuren mit gleichen Bezugszeichen versehen.

Figur 1: Auf einem, zum Beispiel aus Glas bestehenden transparenten Substrat 1 wird ganzflächig die, aus zum Beispiel mit Fluor dotierten Zinnoxid bestehende Grundelektrodenschicht 2 aufgedampft und darauf die aus einer Folge amorpher Siliziumschichten der Struktur nip oder pin bestehende aktive, halbleitende Schicht 3 (im Detail in den Figuren nicht dargestellt) aufgebracht. An der mit dem Pfeil 4 gekennzeichneten Stelle hat sich beispielsweise in der amorphen Siliziumschicht 3 eine Fehlstelle bzw. ein Loch gebildet, welches einen Kurzschluß der beiden Elektroden - (2, 6) der Solarzelle auslösen kann. Die mit der Fehlstelle 4 behaftete amorphe Siliziumschicht 3 wird dann ganzflächig mit einem lichtempfindlichen und elektrisch isolierenden Lack 5 zum Beispiel auf der Basis Novolak/Epoxy/Photopolymer versehen.

Figur 2: Nun wird die Anordnung (1, 2, 3, 4, 5) von der Substratseite 1 her mit zum Beispiel UV-Licht (siehe Pfeile 7) belichtet, wobei die photoempfindliche Lackschicht 5 nur in den Bereich 5a vernetzt wird, in dem, bedingt durch die Fehlstelle 4, durch das transparente Substrat 1 und die transparente Grundelektrodenschicht 2 Licht auf die Lackschicht 5 trifft. Die 0,5 μm dicke amorphe Siliziumschicht 3 ist in allen fehlstellenfreien Bereichen undurchlässig für das UV-Licht 7; die Lackschicht bleibt in diesen Bereichen deshalb unbelichtet.

Figur 3: Der nicht belichtete Lack 5 wird mittels Butyldiglykol, welches amorphes Silizium nicht angreift, von der Siliziumoberfläche 3 abgelöst, wobei nur die über der Fehlstelle 4 liegende vernetzte Lackstruktur 5a bestehen bleibt.

Figur 4: Anschließend wird die aus Silber oder Palladium bestehende Gegen-oder Deckelektrodenschicht 6 aufgebracht. Wie aus der Figur 4 zu ersehen ist, wird die Grundelektrode 2 durch die, durch den vernetzten Lack 5a gebildete Isolationsschicht von der Deckelektrodenschicht 6 getrennt, so daß an den kritischen Stellen (zum Beispiel bei Solarzellen unter dem Grid) keine Kurzschlüsse mehr auftreten können.

## Ansprüche

1. Verfahren zur Vermeidung von Kurzschlüssen bei der Herstellung von elektrischen Bauelementen mit zwei übereinanderliegenden, durch eine isolierende oder halbleitende Schicht getrennten Elektroden, **dadurch gekennzeichnet,** daß

a) ein lichtempfindlicher Lack (5) ganzflächig auf die, die Kurzschlüsse verursachende isolierende oder halbleitende Schicht (3), die sich auf der ersten Elektrodenschicht (2) befindet, aufgebracht wird, wobei der Lack (5) so beschaffen ist, daß bei seiner Belichtung (7) durch in der darunterliegenden isolierenden oder halbleitenden Schicht - (3) befindliche Fehlstellen (4) oder Löcher in der darüberliegenden Lackschicht (5) eine andere Lacklöslichkeit auftritt als in den übrigen Bereichen,

b) unter Ausnutzung der unterschiedlichen Lacklöslichkeiten (5, 5a) der Lack (5) auf der isolierenden oder halbleitenden Schicht (3) selektiv entfernt wird,

c) die zweite Elektrodenschicht (6) ganzflächig aufgebracht wird, und

d) wenn die belichteten Bereiche (5a) leichter löslich sind als die unbelichteten Bereiche (5) vorher eine zusätzliche Isolationsschicht unter Verwendung der stehengebliebenen Lackstrukturen - (5) als Maske abgeschieden wird.

2. Verfahren nach Anspruch 1, **dadurch gekennzeichnet** , daß nach Verfahrensschritt a) als lichtempfindlicher Lack (5) ein durch Belichtung - (7) leichter löslicher Lack (Positivlack) verwendet wird und daß die verbleibenden Lackstrukturen nach Verfahrensschritt d) als Aufdampf-oder Sputter-Maske und/oder als Ätzmaske für die darunterliegende Schicht verwendet wird.

3. Verfahren nach Anspruch 1, **dadurch gekennzeichnet,** daß nach Verfahrensschritt a) als lichtempfindlicher Lack (5) ein durch Belichtung - (7) vernetzender Lack (Negativlack) verwendet wird und daß die verbleibende Lackstruktur (5a) im Bereich der Fehlstellen (4) oder Löcher nach der Abscheidung der zweiten Elektrodenschicht (6) nach Verfahrensschritt c) in Lösung gebracht und dadurch mittels der sogenannten Abhebetechnik die über den Lackstrukturen (5a) liegenden Bereiche der zweiten Elektrodenschicht (6) mitentfernt werden.

4. Verfahren zur Vermeidung von Kurzschlüssen bei der Herstellung von aus amorphen Siliziumschichten (4) bestehenden Dünnschichtsolzarllen, die durch Abscheiden der Schichtenfolge: transparente Grundelektrode (2) - aktive amorphe Siliziumschicht (3) -Deckelektrode - (6) auf großflächigen transparenten Substraten (1) erzeugt werden, **dadurch gekennzeichnet,** daß

a) ein lichtempfindlicher und elektrisch isolierender, durch Belichtung (7) vernetzender Lack (5) auf die, die Kurzschlüsse verursachende aktive amorphe Siliziumschicht (3), die sich auf der, auf dem transparenten Substrat (1) angeordneten transparenten Grundelektrodenschicht (2) befindet, aufgebracht wird,

b) die Anordnung (1, 2, 3, 4, 5) von der Substratseite (1) her belichtet wird (7),

c) die durch Belichtung (7) nicht vernetzten Teile der Lackschicht (5) mit einem das amorphe Silizium (3) nicht angreifende Lösungsmittel entfernt werden und d) die Deckelektrodenschicht (6) ganzflächig auf die mit den vernetzten Lackstrukturen (5a) versehene Anordnung (1, 2, 3) aufgebracht wird.

5. Verfahren nach Anspruch 4, **dadurch gekennzeichnet** , daß in einem zusätzlichen Verfahrensschritt durch die bekannte Abhebetechnik die vernetzten Lackstrukturen (5a) in einem Lösungsmittel gelöst und dabei die über diesen Lackstrukturen (5a) liegenden Bereiche der Deckelektrodenschicht (6) mitabgehoben werden.

6. Verfahren nach Anspruch 4 oder 5, **dadurch gekennzeichnet**, daß als Substrat (1) eine Glasplatte, als Grundelektrodenschicht (2) eine mit Fluor dotierte Zinnschicht, als amorphe Siliziumschicht (3) die Strukturfolge nip oder pin, als lichtempfindlicher Lack (5) ein Photolack auf der Basis Novolak/Epoxy/Photopolymer und als Deckelektrodenschicht (6) eine Silber-oder NickelChrom-Schicht verwendet wird.

7. Verfahren nach einem der Ansprüche 4 bis 6, **dadurch gekennzeichnet**, daß zur Bestrahlung nach Verfahrensschritt b) UV-Licht (7) vorzugsweise im Bereich von 350 bis 400 nm verwendet wird.

# FIG 1

# FIG 2

# FIG 3

# FIG 4